Europäisches Patentamt

European Patent Office

Office européen des brevets

(11) Publication number: **0 506 094 A2**

# EUROPEAN PATENT APPLICATION

(21) Application number: **92105324.5**

(51) Int. Cl.⁵: **G06J 1/00**

(22) Date of filing: **27.03.92**

A request for addition of a second priority has been filed pursuant to Rule 88 EPC. A decision on the request will be taken during the proceedings before the Examining Division (Guidelines for Examination in the EPO, A-V, 2.2).

(30) Priority: **29.03.91 JP 91155/91**

(43) Date of publication of application:
**30.09.92 Bulletin 92/40**

(84) Designated Contracting States:
**DE FR GB IT**

(71) Applicant: **HITACHI, LTD.**
**6, Kanda Surugadai 4-chome**
**Chiyoda-ku, Tokyo 101(JP)**

(72) Inventor: **Okado, Kazuo**
**Hitachi-seiwaryo, 769, Shin-machi**
**Ohme-shi, Tokyo(JP)**
Inventor: **Akojima, Chikara**
**102, Riidohaitsu, 1-26-13, Matsubara-cho**
**Akishima-shi, Tokyo(JP)**
Inventor: **Kenmoku, Atuko**
**101, Shatouwakakusa, 505-14, Kabe**
**Ohme-shi, Tokyo(JP)**
Inventor: **Sugino, Kimihiro**
**303, Dominansu kabe, 3-1120-3, Kabe-cho**
**Ohme-shi, Tokyo(JP)**

(74) Representative: **Strehl, Schübel-Hopf,**
**Groening**
**Maximilianstrasse 54 Postfach 22 14 55**
**W-8000 München 22(DE)**

(54) **A semiconductor integrated circuit and a data processor.**

(57) In a digital-analog hybrid LSI including an analog circuit (2) and a digital circuit (3), the analog circuit (2) includes a circuit for sampling, according to the operation timing of a switch (4), information to be processed by the analog circuit (2) in a capacitor (5). A clock signal generating means (6) generates an operation reference clock signal (b) for the digital circuit (3) so that the change of the clock signal (b) is stopped at a timing when the switch (4) is opened, i.e., during a specified period (T) which includes the high-to-low transition timing of the clock signal. This prevents the analog characteristic of the analog circuit (3) from being degraded by digital noise that is transferred through the junction capacitance of the semiconductor chip (1).

*FIG. 1*

EP 0 506 094 A2

BACKGROUND OF THE INVENTION

The present invention relates to a digital-analog hybrid type semiconductor integrated circuit having a digital and an analog circuit formed in the same semiconductor chip, and to a data processor that can be used as the digital circuit in the semiconductor integrated circuit. This invention also relates to an art that is effectively applicable to the digital-analog hybrid type semiconductor integrated circuit incorporated in equipment used in such communications and signal processing fields as codec, modem, echo canceler, mobile radio and image processing.

Semiconductor integrated circuits are available which have analog and digital circuits formed in a single semiconductor chip by CMOS or Bi-CMOS process. For example, in the fields of voice recognition, modem and ISDN are used analog-digital hybrid LSIs which have on-chip circuits such as an analog/digital convertor to convert analog signals into digital signals and a digital/analog convertor for the reverse conversion, in addition to an on-chip digital signal processor used for digital signal processing such as filtering, equalizing, removal of echoes, extraction of signal characteristic parameters and image emphasizing. Literatures covering such digital-analog hybrid LSIs include Japan Patent Laid-Open No. 217706/1988.

Conventional data processors such as digital signal processors that are controlled by micro programs have an architecture where they read micro instructions one by one from a control memory and execute them in order. Digital signal processors that support so-called pipeline processing have the similar architecture. Among the literatures describing digital signal processing is "Transistor Gijutsu (transistor technology)" p.395-p.401 CQ Shuppansha, Feb. 1989.

SUMMARY OF THE INVENTION

When the analog circuit and the digital circuit, both formed on the same semiconductor chip, operate in synchronism, the author has found that digital noise produced by the operation of the digital circuit in some cases deteriorates the characteristics of the analog circuit. That is, when the digital circuit operates, a relatively large current flows through a power supply line depending on the operating conditions, causing variations in the supply voltage, or the junction capacitance formed between a transistor diffusion layer and the semiconductor chip is charged/discharged according to the transistor operations. Such voltage variations and the charging/discharging of the junction capacitance produce noise through the semiconductor chip. The noise thus produced is also transferred to the analog circuit that shares the same semiconductor chip with the digital circuit. Take, for example, an analog circuit that includes an A/D convertor and a local D/A convertor using a switched capacitor integrating circuit and a plurality of appropriately weighted capacitor arrays. During the capacitor sampling performed at the switch operation timing, when the accumulation node of the capacitor is given potential variations by digital noise through junction capacitance, it has been found that errors occur in the amount of charge to be sampled, degrading the operation accuracy of the analog circuit. Characteristics deterioration of the analog circuit due to digital noise is not limited to this. Crosstalk with the power line whose supply voltage and level are varied because of noises deteriorates the characteristics.

There has been a trend that semiconductor integrated circuits will have a larger scale integration because of the manufacturing technological advance and that their power consumption will increase because of growing demand for high-speed operation. This in turn increases digital noise. At the same time, as the range of its application widens, the analog circuit has a greater demand for enhanced accuracy. Under these circumstances, the characteristic degradation of the analog circuit due to digital noise in digital-analog hybrid LSIs is expected to become an important issue.

The inventor of this invention conducted studies to prevent digital noise from affecting the analog circuit by operating the digital and analog circuits in a time sharing manner. The analog circuit and the digital circuit, formed on the same semiconductor chip, however, must be operated synchronously. The operation speed of an analog circuit such as A/D convertor is often determined by the performance of a system being processed, such as its operation speed and bit accuracy. This means that the operation speed of the analog circuit has a relatively low degree of freedom with respect to the system being processed. The inventor has found it desirable to stop the operation of the digital circuit when the analog circuit is operated. However, in an architecture that requires at least one machine cycle to execute one micro instruction, as employed by conventional data processors such as digital signal processors, it is impossible to provide a sufficient time to stop the digital circuit operation during the analog circuit operation. On the contrary, increasing the operation clock frequency of the digital signal processor results in an increased power consumption, making this method inappropriate for those LSIs power supply to which is limited, such as centralized power supply from an exchange or battery supply. Moreover, this method is found to pose another problem of increasing the digital noise. The inventor therefore has found it necessary to reduce the number of machine cycles for executing a predetermined processing in order to secure such a sufficient time duration.

The object of this invention is to prevent degradation of analog characteristics caused by digital noise in the digital-analog hybrid type semiconductor integrated circuit. For prevention of analog characteristic degradation due to digital noise, another object of the invention is to realize a margin in time to stop the digital circuit operation during the analog circuit operation by reducing the number of machine cycles required for executing a predetermined processing. Still another object of the invention is to reduce the number of machine cycles in which the data processor executes a predetermined processing.

These and other objects and novel features of this invention will become apparent from the following description in the specification and the accompanying drawings.

Representative one of the inventions disclosed in this application are briefly explained below.

In the semiconductor integrated circuit having analog and digital circuits formed in a single semiconductor chip, a means is provided to generate timing to stop the digital circuit operation upon the specified operation of the analog circuit.

When the analog circuit includes circuits, such as A/D convertor and local D/A convertor using switched capacitor integral circuits and capacitor arrays, which access capacitors according to the switch operation timing for sampling information to be processed, the digital circuit operation is stopped for a specified period including the sampling operation.

Such means to generate timing may be a clock signal generating means that generates operation reference clock signals for stopping the change of the operation reference clock signals of the digital circuit that are kept from changing in a specified period including a transition timing of the clock signal for controlling the sampling switch.

Since the operation speed of the analog circuit is determined solely or with a little, if any, degree of freedom by such factors as the operation speed and bit accuracy of the system being processed, it is desired that the margin in time for allowing the digital circuit operation to stop during the analog circuit operation be realized by improving the processing capacity of the digital circuit or by reducing the number of machine cycles required for a specified sequence of processing. For this end, the digital circuit such as digital signal processor must employ an instruction control means which executes a non-arithmetic instruction in parallel with the execution of an arithmetic instruction. The arithmetic instruction is an instruction to perform calculation on specified data by using multiplier and calculator. The non-arithmetic instruction on the other hand is used when the operation procedure of the digital circuit is determine on the basis the transient states of the processing inside and outside the semiconductor integrated circuit on which the digital circuit is mounted. The non-arithmetic instruction is intended to detect or set such transient states of the processing.

When a single control memory contains the arithmetic instructions and the non-arithmetic instructions, the non-arithmetic instructions are read out from the control memory and executed at the same time that the arithmetic instructions are being executed. This is achieved by so configuring the instruction control means that, while particular arithmetic instructions read from the control memory are held in a register or the like for multiple operation cycles and are repetitively decoded by the first instruction decoder for the execution of the instructions, non-arithmetic instructions are read from the control memory and decoded by the second instruction decoder for the execution.

Where the control memory has separate memory spaces for the arithmetic instruction control system and for the non-arithmetic instruction control system, it is possible to provide a program counter to each control memory and a control means so as to synchronously operate the program counter in either of the arithmetic and the non-arithmetic instruction control system according to the instruction execution state in the other control system, and to perform parallel instruction execution in the two control systems at desired timings.

Because the instruction control means executes a non-arithmetic instruction while executing a particular arithmetic instruction repetitively, it is suited for such applications as echo cancelers in which similar calculations must be carried out repetitively like an application filter processing.

The above-mentioned configuration of the instruction control means that allows the parallel processing of the arithmetic and the non-arithmetic instructions can independently be applied to the data processor.

Stopping the operation of the digital circuit when the analog circuit mounted on the same semiconductor chip is operating prevents deterioration in analog characteristic or operation precision of the analog circuit that might be caused by digital noise. For example, when an analog circuit, such as A/D convertor or local D/A convertor that uses switched capacitor integrating circuits and capacitor arrays, accesses capacitors according to the switch operation timing to retrieve information to be processed, the digital circuit is not operated, so that the levels at the accumulation nodes of the capacitors are not subjected to potential variations caused by digital noise transferred through junction capacitance, thereby permitting the information to be accumulated with a desired accuracy.

Since the operation speed of the analog circuit is determined solely or with a little, if any, degree of freedom by the operation speed and bit accuracy of the system to be processed, the margin in time or capacity needed to stop the operation of the digital circuit during the analog circuit operation must be provided to the digital circuit. In this case when the digital circuit like a digital signal processor execute non-arithmetic instructions in parallel with the execution of the arithmetic instructions, the number of machine cycles needed for a specified processing in the digital circuit is reduced and the margin in time or capacity that allows the digital circuit to be stopped during the analog circuit operation. Further, the reduced machine cycle number for a series of processings made possible by the parallel execution of arithmetic and non-arithmetic processing also contributes to the improvement of the processing capacity of the data processor itself, such as a digital signal processor, as well as to the improvement of the performance of the digital-analog hybrid semiconductor integrated circuit.

Since the above-mentioned measure of the digital circuit to eliminate the need to increase the operation frequency of the digital circuit, they tend to suppress an increase in the power consumption and digital noise.

While specified arithmetic instructions read from the control memory are held in a register for multiple operation cycles and repetitively decoded by the first instruction decoder for execution, non-arithmetic instructions are read from the control memory, decoded by the second instruction decoder and executed. This parallel operation enables the parallel execution of the arithmetic and the non-arithmetic instructions even when the two kinds of instructions are held in a single control memory.

Since, according to the instruction execution state of either of the arithmetic and non-arithmetic instruction control systems, the state of the program counter in the other control system is controlled to perform parallel operation of the two control systems, the arithmetic and the non-arithmetic instructions can be executed parallelly even when separate control memories are used to separately control the arithmetic instruction control system and the non-arithmetic instruction control system.

## BRIEF DESCRIPTION OF THE DRAWINGS

Figure 1 is an embodiment of a digital-analog hybrid LSI according to this invention which stops the operation of a digital circuit while an analog circuit is being operated;
Figure 2 is a block diagram of an echo canceling LSI of another embodiment of the digital-analog hybrid LSI according to the invention;
Figure 3 is a diagram showing the working principle of an oversampling type A/D convertor;
Figure 4 is a circuitry of an analog integrating circuit and a local D/A convertor contained in the oversampling type A/D convertor;
Figure 5 is a diagram illustrating operation clock signals of the circuit of Figure 4;
Figure 6 is a timing diagram showing the relationship between the operation clock signals of the analog circuit and the digital circuit;
Figure 7 is a block diagram illustrating the function achieved by the echo canceling LSI of Figure 2;
Figure 8 is an example diagram showing in principle the parallel execution state of arithmetic instructions and non-arithmetic instructions;
Figure 9 is a block diagram of an embodiment of an instruction control block for parallelly executing arithmetic instructions and non-arithmetic instructions;
Figure 10 is a timing diagram showing the control operation of the instruction control block of Figure 9;
Figure 11 is a block diagram of another embodiment of the instruction control block for parallelly executing arithmetic instructions and non-arithmetic instructions;
Figure 12 is a diagram showing an example of application filter processing algorithm used in an echo canceler;
Figure 13 is an embodiment of a calculation block that makes up the application filter;
Figure 14 is a diagram showing an embodiment of a flag processing block; and
Figure 15 is a diagram showing an embodiment of a timing generator.

## DESCRIPTION OF THE PREFERRED EMBODIMENT

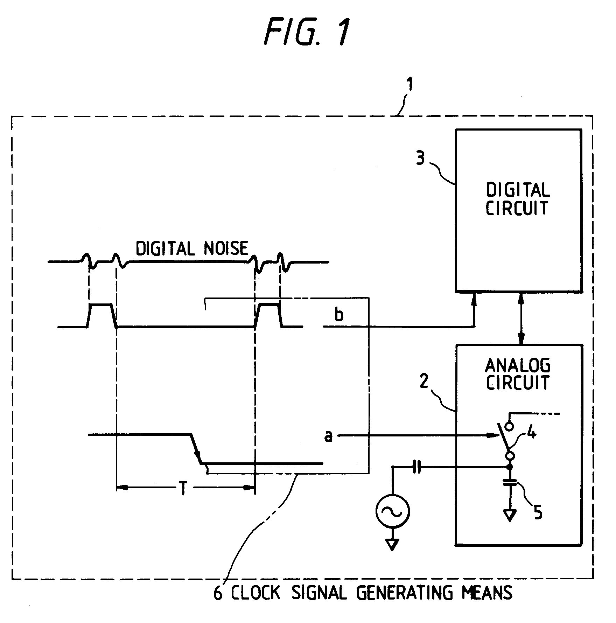

Figure 1 shows schematically an embodiment of a digital-analog hybrid LSI according to this invention. The digital-analog hybrid LSI shown in the figure has an analog circuit 2, a digital circuit 3 and a clock signal generating means 6, all mounted in a single semiconductor chip 1. The digital circuit 3 contains a data processor such as digital signal processor, though not limited to this; and the analog circuit 2 includes an A/D convertor and a local D/A convertor which use switched capacitor integrating circuits and capacitor arrays, though not limited to this. Shown representatively in the analog circuit 2 of the figure is a part of a circuit that samples a piece of information to be processed in the analog circuit and hold it in a capacitor 5 according to the operation timing of a switch 4. Let a clock signal for controlling the switch 4 be a and an operation reference clock signal for the digital circuit 3 be b. When the clock signal a goes to a low level to open the switch 4, the amount of charge sampled and held in the capacitor 5 is determined by a voltage applied to the storage electrode of the capacitor 5 when the switch 4 is about to be opened. During a specified operation period of the analog circuit 2 including such high-to-low transition timing of the clock signal a, the operation of the digital circuit 3 is stopped. That is, the clock generating means 6 generates the operation reference clock signal b for the digital circuit 3 that will not change during the specified period T including the high-to-low transition timing of the clock signal a. As a result, even when digital noise that occurs in synchronism with the transition timing of the operation reference clock signal b for the digital circuit 3 is transferred through the junction capacitance of the semiconductor chip 1 and changes the level of the storage electrode of the capacitor 5, such level changes always occur at different times from the sampling timings of the capacitor 5, thereby completely protecting the analog characteristics of the analog circuit 2 from being degraded by the digital noise.

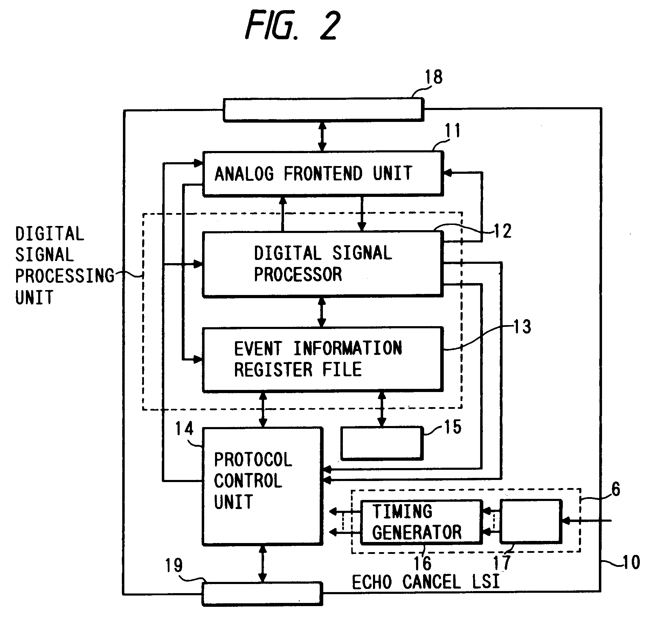

Figure 2 shows another embodiment of the digital-analog hybrid LSI according to this invention. The digital-analog hybrid LSI shown in the figure is an echo cancel LSI 10, consisting of an analog front-end unit 11 as an example of analog circuit, a digital signal processor 12 and other circuits, all formed in a single semiconductor chip. The analog front-end unit 11 includes an A/D convertor and a D/A convertor. The overall configuration and function of the echo cancel LSI 10 will be described later.

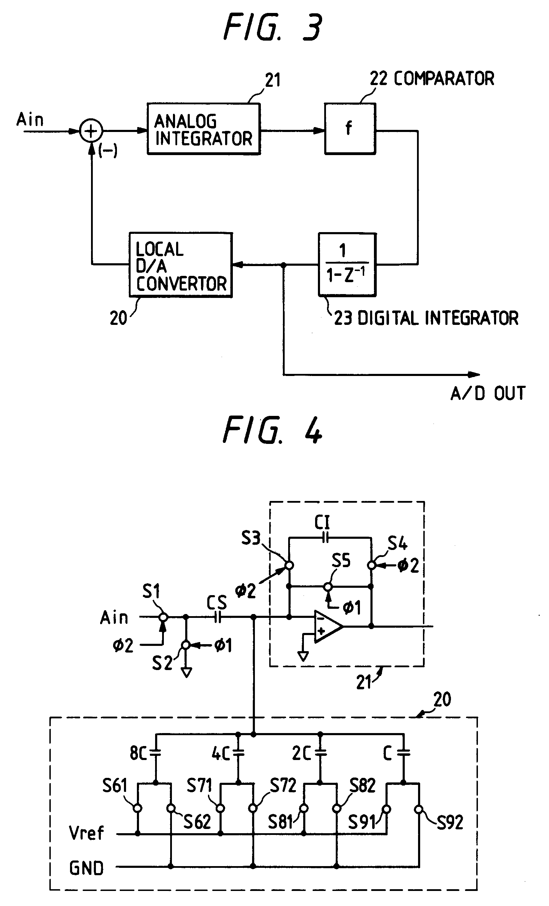

Figure 3 shows a schematical configuration of the oversampling type A/D convertor as an example of the A/D convertor. In the oversampling type A/D convertor, the voltage difference between the analog input voltage $A_{in}$ and the output voltage of the local D/A convertor 20 is integrated by an analog integrator 21 (error integration) and the result of integration is quantized by a comparator 22 and then integrated by a digital integrator 23. The output of the digital integrator 23 is fed back to the local D/A convertor 20. This feedback loop causes the output of the local D/A convertor 20 to follow the analog input voltage $A_{in}$. Hence, the output of the digital integrator 23 is taken as the output of the oversampling type A/D convertor.

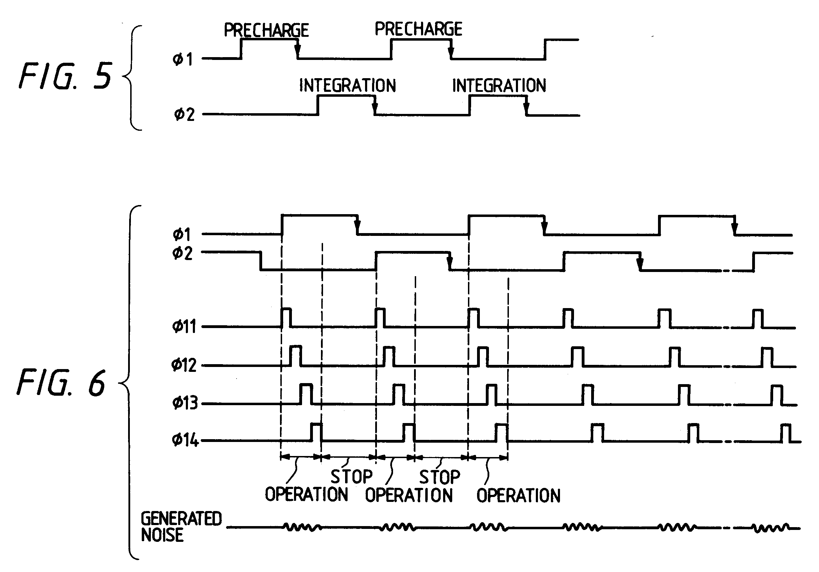

Figure 4 shows a detailed example of the local D/A convertor 20 and the analog integrator 21. The circuit shown uses switched capacitors. Denoted S1 to S5, S61, S62, S71, S72, S81, S82, S91, S92 are switches such as CMOS transfer gates; CI and CS are capacitors on the side of the analog integrator 21; and C, 2C, 4C, 8C are capacitors on the side of the local D/A convertor 20 which are weighted with powers of 2. The switches S2, S5 on the side of the analog integrator 21 are controlled by a clock signal $\phi1$ and the switches S1, S3, S4 are controlled by a clock signal $\phi2$. These two clock signals $\phi1$, $\phi2$ are of non-overlapping two-phase clock signals, as shown in Figure 5. The clock signal $\phi1$ controls the precharge operation by its high-level period, during which it turns on the switches S2, S5. At this time, the local D/A convertor 20, according to the sign of the digital signal supplied, turns on one of left and right switches coupled to the lower electrode of each capacitor C, 2C, 4C, 8C to take in either the reference potential $V_{ref}$ or the ground potential GND. The operation timing of these switches is synchronized to the clock signal $\phi1$. The high-level period of the clock signal $\phi2$ controls the integration operation, during which it turns on the switches S1, S3, S4 of the analog integrator 21. At this time, the local D/A convertor 20 reverses the status of the switches connected to the lower electrode of the capacitors C, 2C, 4C, 8C. For example, when the digital signal supplied represents '1010' and if the switches S61, S72, S81, S92 are on and the switches S62, S71, S82, S91 are off during the precharging period, then the states of these switches are inverted during the integration operation. In this way, the output voltage of the local D/A convertor 20 is set and its voltage difference relative to the analog input voltage $A_{in}$ is integrated.

In the circuit shown in Figure 4, the timing when the analog circuit operation precision is most affected by noise or crosstalk transferred through the semiconductor chip is when the precharge and integration operation are finished, i.e., at the timing when the switches S1-S5, S61, S62, S71, S72, S81, S82, S91, S92 are reversed to the off state to determine the amount of capacitors sampling charge. According to Figure 4 and 5, this timing is the one when the clock signals $\phi1$, $\phi2$ change their state from high-level to low-level. In the echo cancel LSI shown in Figure 2, the digital signal processor is always stopped at this timing.

Figure 6 shows examples of timings of the operation reference clock signals of the digital signal processor 12 with respect to the clock signals $\phi1$, $\phi2$. In this example, the digital signal processor 12 is controlled by four-phase operation reference clock signals, $\phi11$, $\phi12$, $\phi13$, $\phi14$. In the period when all these clock signals are at low level, the digital signal processor 12 stops its access to the internal memory and computation. This halt period includes the high-to-low transition timing of the clock signals $\phi1$, $\phi2$. Such a

timing control is performed by the timing generator 16 incorporated in the echo cancel LSI 10 shown in Figure 2. Since, when the digital signal processor 12 operates in synchronism with the analog front-end unit 11, the digital signal processor 12 stops its operation at the sampling timing of the analog integrator 21 and local D/A convertor 20, the analog operation characteristic of the analog front-end unit 11 can be prevented from being degraded by digital noise.

Since the operation speed of the analog circuit is determined solely by or with a little, if any, degree of freedom by the operation speed and bit accuracy of the system being processed, it is desired that the extra time or processing capability for allowing the digital circuit operation to stop during the analog circuit operation be realized by improving the processing capability of the digital circuit or by reducing the number of machine cycles required for a specified sequence of processing. Now, the architecture of the digital signal processor that meets this requirement will be explained by taking the echo cancel LSI 10 as an example.

First, an overall configuration of the echo cancel LSI 10 will be described by referring to Figure 2. The echo cancel LSI 10 includes an analog front-end unit 11, a digital signal processor 12, an event information register file 13, a protocol control unit 14, a timer counter unit 15, a timing generator 16, an analog phase-locked loop circuit 17, a U-point interface circuit 18, and an S-point interface circuit 19. The echo cancel LSI 10 is formed on a single semiconductor chip such as a silicon chip by a known technique like Bi-CMOS process. The digital signal processor 12 and the event information register file 13 constitute a digital signal processing unit. The digital signal processor 12 consists of a control block and a calculation block. The control block references the event information register file 13 and according to a specified procedure executes a micro program. The digital signal processor 12 makes the calculation block work as an application filter to realize an echo canceler and the like. The analog front-end unit 11 performs D/A conversion on transmitting signals and A/D conversion on receiving signals. The U-point interface circuit 18 is connected to the exchange through a hybrid transformer or a balancing network circuit. The event information register file 13 is a register to hold transient states occurring in the digital signal processor 12 and the protocol control unit 14. These units 12, 14 detect the transient states set in the event information register file 13 to determine their operation and also sets the transient states according to the contents to be processed. The protocol control unit 14 performs a protocol processing, which includes transmission processing such as framing and scrambling and reception processing such as synchronization. The timer counter unit 15 is used for state transition control, and the timing generator 16 generates various operation clock signals for the echo cancel LSI 10. The analog phase-locked loop circuit 17 multiplies a system clock signal supplied from outside and feeds it to the timing generator 16. The S-point interface circuit 19 interfaces with a subscriber.

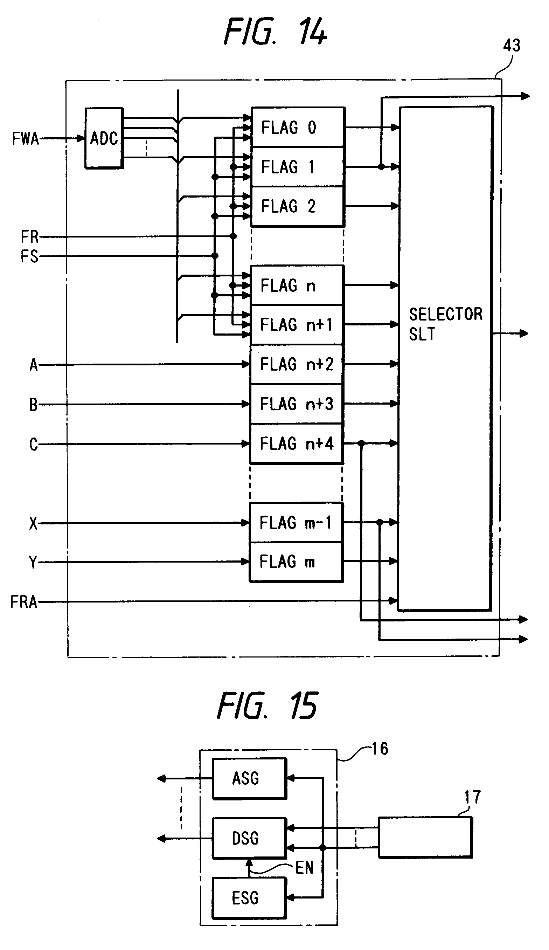

Figure 15 shows an embodiment of the timing generator 16. The timing generator includes an analog signal generating circuit ASG, a digital signal generating circuit DSG, and an enable signal generating circuit ESG. The digital signal generating circuit DSG receives multiple phases of clock signals of a predetermined period from the analog phase-locked loop circuit 17 to form a clock signal for digital circuit operation. The analog signal generating circuit ASG receives a specified one of multiple phases of clock signals from the analog phase-locked loop circuit 17 to form a clock signal for analog circuit operation. The enable signal generating circuit ESG receives a specified clock signal from the phase-locked loop circuit 17 to generate an enable signal EN. The digital signal generating circuit DSG outputs a digital circuit operation clock signal while it receives the enable signal EN. With the digital signal generating circuit DSG controlled by the enable signal EN, the digital circuit operation clock signal is prevented from being output from the timing generator 16 for a specified period which, as shown in Figure 1 or 6, includes the high-to-low transition timing of the analog circuit operation clock signal.

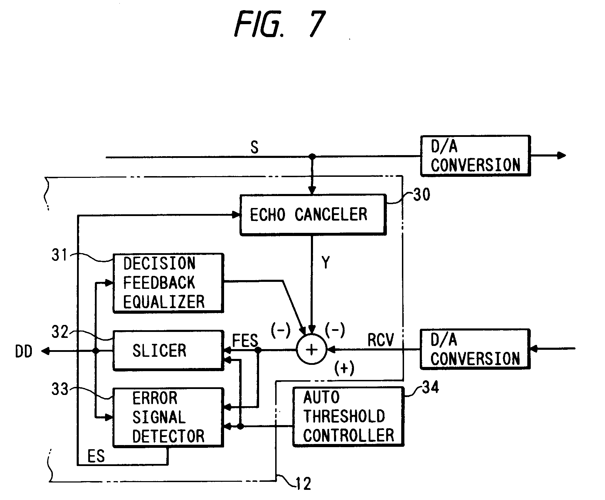

Figure 7 shows a block diagram illustrating the function of when the echo cancel LSI 10 used as an echo canceler. In the figure, designated 30 is an echo canceler, and 31 a decision feedback equalizer, both realized by application filters. Designated 32 is a slicer to slice input signals into four-value levels, and the slicer outputs decision data DD made up of one-bit sign data and two-bit information data. Denoted 33 is an error signal detector to form an error signal ES; and 34 an auto threshold controller to generate a level-to-level voltage (slice voltage) $V_{ref}$ for four-value levels. The digital signal processor 12 realizes these functions according to their operation sequence.

Signals S such as transmitting data output from the protocol control unit 14 are, for example, 3-bit signals which are made up of one-bit sign data and two-bit information data and represent one of four values. The signals S are D/A-converted and given to a balancing network circuit not shown. Received analog signals input to the balancing network circuit are A/D-converted into digital signals, which are then fed to the digital signal processor 12. The echo cancel LSI 10 can perform a full duplex operation, i.e., a simultaneous operation of transmission and reception. The balancing network circuit prevents a part of the signal to be transmitted via the D/A convertor from interfering with the A/D convertor side through the hybrid transformer by taking into account the impedance of the hybrid transformer coupled to the circuit and by removing the voltage component of the sending analog signal from the voltage component applied to the hybrid transformer from the circuit. This method of preventing interference is realized under the assumption that the impedance of the circuit is always constant. In reality, however, there are variations in impedance of the circuit, the condition of the circuit changes over time, and it is totally impossible to foretell the condition of the circuit to which the balancing network circuit will be connected. Under these circumstances an echo canceler 30 needs to be used to reliably eliminate the echo components entering the receiving side from the sending side.

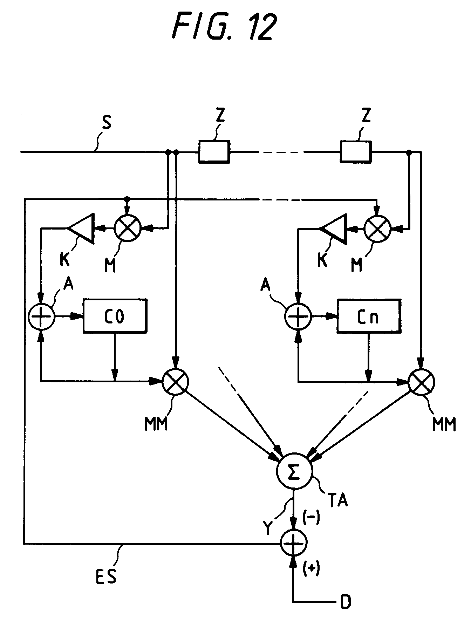

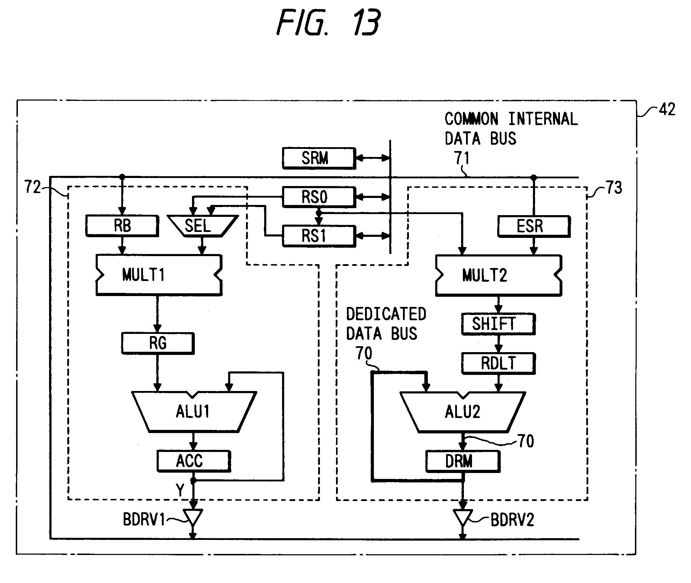

In the circuit of Figure 13, the echo canceler 30 receives one signal S in one sample period and performs calculation for all taps according to the algorithm of the application filter of Figure 12 to produce a filter output signal Y. The echo component D is canceled by the filter output signal Y. The decision feedback equalizer 31 also performs the similar application filter calculation. The filter outputs of the echo canceler 30 and the decision feedback equalizer 31 are subtracted from a signal RCV (a receiving signal containing echo components)—which has been A/D-converted in one sample period—to produce a far end signal FES, a transmitted signal whose echo components or inter-sign interference components are partly or totally eliminated. The far end signal FES is sliced by the slicer 32 into four-value levels to form decision data DD. The error signal detector 33 subtracts from the far end signal FES the product of the decision data DD and the slice voltage $V_{ref}$ to form an error signal ES and gives it to the echo canceler 30 and the decision feedback equalizer 31. The echo canceler 30 and the decision feedback equalizer 31 use the error signal ES for the tap coefficient update calculation. During the training period, the signal S is taken as a training signal and the signal RCV at this time is taken virtually as an echo component of the training signal. The echo canceler 30 and the decision feedback equalizer 31, as application filters, perform iterative operations to update the tap coefficient so that the error signal ES converges to zero. And at the end of the training period, the far end signal FES is obtained whose echo components are canceled virtually completely. During communication after the training, these two circuits operate to cancel echo according to the varying conditions of the circuit. The decision data DD is given as receiving data to the protocol control unit 14.

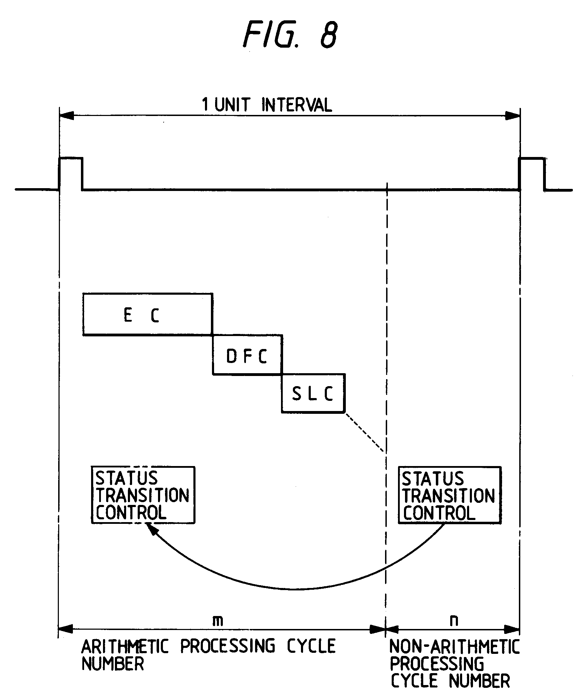

The echo cancel LSI 10 takes a cycle defined by the frequency of, say, 80 kHz as a unit interval for one sample data, and performs in each interval non-arithmetic processing—which includes such condition branch and flag processing as transition state detection and state setting—and digital signal processing. The digital signal processing includes the processing performed by the echo canceler, decision feedback equalizer and slicer. The control of deciding which processing should be done under what situation is realized by a state transition control, which is determined by the condition branch and flag processing such as transition state detection and state setting. The digital signal processing is done by repetitively performing the arithmetic instructions, whereas the state transition control is carried out by the non-arithmetic processing. In this embodiment, the non-arithmetic instructions for the state transition control are executed in parallel with the digital signal processing. For example, as shown in Figure 8, the arithmetic processing—which includes such processing as echo cancel (EC) performed by the echo canceler 30, decision feedback equalize (DFE) by the decision feedback equalizer 31 and slice (SLC) by the slicer 32—and the non-arithmetic processing for the state transition control—such as condition branch and flag processing which does not use data memory nor calculator—are not carried out sequentially but parallelly in a unit interval. That is, the non-arithmetic processing is performed simultaneously, for example, with the echo cancel (EC). This reduces the number of cycles taken by the digital signal processing unit 12 to process the specified amount of operation in one unit interval from m + n to m. The length of one unit interval is determined by the operation speed of the analog front-end unit 11, i.e., the operation speed and bit accuracy of the target system being processed by the digital signal processing unit 12. By reducing the number of operation cycles that the digital signal processor 12 requires to execute a specified amount of processing during that period, it is possible to use the reduced-operation-cycle time for stopping the operation of the digital signal processor 12 while the analog front-end unit 11 is operating. In this embodiment, the frequency of the operation reference clock signal for the digital signal processor 12 is lowered so that a part of the resulting extended cycle time is allocated as the time for stopping the operation of the digital signal processor 12 as shown in Figure 6. Lowering the frequency of the operation reference clock signal for the digital signal processor 12 contributes to reducing the overall power consumption and digital noise of the digital signal processor 12. This makes the echo cancel LSI of the invention suitable for application on systems that are supplied from the exchange or powered by battery and therefore have a limited amount of usable power. While in Figure 8 all the state transition control (STC) is shown to be performed in parallel with the echo cancel (EC) processing, the state transition control (STC) may be spread over the multiple arithmetic processing of the echo cancel (EC), decision feedback equalize (DFE) and slice (SLC) so that the state transition control for the next arithmetic processing may be paralleled with the previous arithmetic processing.

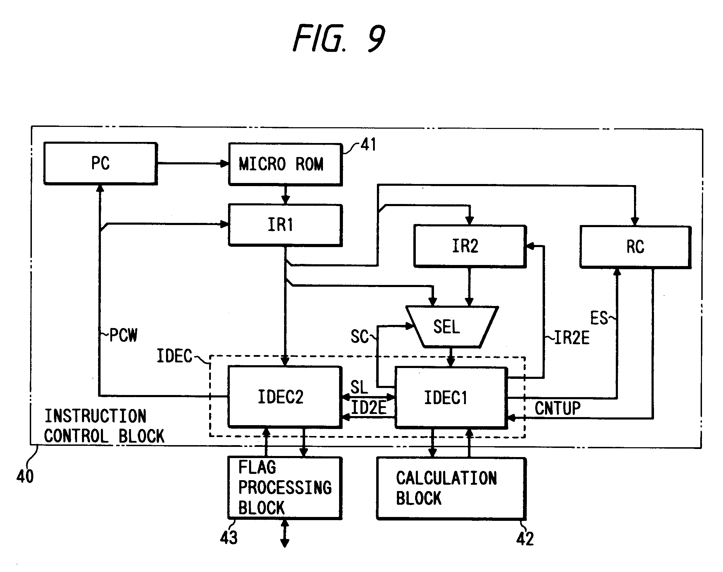

Figure 9 shows an embodiment of an instruction control block of the digital signal processor 12 that performs such parallel processing. Circuit blocks including instruction decoders $IDEC_1$, $IDEC_2$, a calculation block 42 and a flag processing block 43 operate according to transitions in the clock generated by the digital signal generating circuit shown in Figure 15 (see Figure 6).

The instruction control block 40 has a micro ROM 41 as a control memory, which contains a micro program made up of arithmetic instructions for application filter processing of echo cancel and non-arithmetic instructions for state transition control. The access address for the micro ROM 41 is pointed by the program counter PC. For the purpose of executing the arithmetic instructions and the non-arithmetic instructions parallelly, two instruction registers $IR_1$, $IR_2$ are provided to store the micro instructions read out from the micro ROM 41 according to the value of the program counter PC. Also two instruction decoders IDEC are provided for decoding the micro instructions: an arithmetic instruction decoder $IDEC_1$ and a non-arithmetic instruction decoder $IDEC_2$. The selector SEL makes it possible to choose between the instruction registers $IR_1$ and $IR_2$ from which the micro instructions are fed to the instruction decoder $IDEC_1$. A repeat counter RC is a count means to manage the number of times that the iterative instructions are repetitively executed. The instruction decoder $IDEC_2$ has a dedicated logic to decode and execute non-arithmetic instructions for the state transition control. The other instruction decoder $IDEC_1$ has a logic for decoding and executing arithmetic instructions. The control signal output from the instruction decoder $IDEC_1$ controls the internal circuit of the calculation block 42 and the instruction control block 40. The control signal output from the other instruction decoder $IDEC_2$ controls the internal circuit of the flag processing block 43 for the state transition control and the instruction control block 40. The flag processing block 43 is included in the event information register file 13.

In a normal instruction execution sequence, a micro instruction, read from the micro ROM 41 according to the value of the program counter PC as an address, is supplied through the instruction register $IR_1$ and the selector SEL to the instruction decoder $IDEC_1$, which decodes the micro instruction to control the calculation block 42. At this time, the instruction decoder $IDEC_1$ disables the instruction decoder $IDEC_2$ by the control signal ID2E.

The micro ROM 41 contains repeat instructions, which in this example have code information and repeat number information, both information preceding the arithmetic instruction to be executed. The code information is used to generate an internal state for executing the arithmetic instruction repetitively, and the repeat number information specifies the number of times that the arithmetic instruction must be executed repetitively. When a repeat instruction is read from the micro ROM 41 into the instruction register $IR_1$ and further sent through the selector SEL to the instruction decoder $IDEC_1$, the instruction decoder $IDEC_1$ decodes the instruction to set the control signals SC, ID2E, IR2E, and ES to states different from those in the case of the normal instruction execution sequence, and then sets the internal circuits of the instruction control block 40 as follows so as to repetitively execute the arithmetic instruction contained in the repeat instruction stored in the micro ROM 41.

The instruction decoder $IDEC_1$ then outputs an enable signal ES to the repeat counter RC so that the execution repeat number contained in the repeat instruction latched by the instruction register $IR_1$ can be preset in the repeat counter RC. Upon receiving the enable signal ES, the repeat counter RC takes in the execution repeat number from the instruction register $IR_1$. In the next operation cycle, another micro instruction to be executed repetitively is read out from the micro ROM 41 and similarly decoded by the instruction decoder $IDEC_1$ for execution. At this time, the instruction decoder $IDEC_1$ applies a control signal IR2E to the instruction register $IR_2$ to transfer only the instruction output from the instruction register $IR_1$ to the instruction register $IR_2$. In the succeeding instruction execution cycles, the instruction decoder $IDEC_1$ reverses the control signal ID2E to the enable level to enable the other instruction decoder $IDEC_2$ and at the same time switches the selector SEL by the control signal SC to repetitively feed the micro instruction held by the instruction register $IR_2$ to the instruction decoder $IDEC_1$ for repetitive execution. During the iterative execution of the arithmetic instruction, each time the repeat counter RC executes the instruction and decrements the preset value to zero, it sends a countup signal CNTUP to the instruction decoder $IDEC_1$.

During this process, another micro instruction read out from the micro ROM 41 is fed through the instruction register $IR_1$ to the instruction decoder $IDEC_2$. The micro instructions supplied in this way are non-arithmetic instructions for the state transition control and control the flag processing block 43 to execute the state transition control, such as flag processing for conditional branch, in parallel with the arithmetic processing performed by the calculation block 42. The number of times that the instructions for the state transition control are executed is small compared with the number of repetitive executions of the arithmetic

8

instructions. Hence, when the state transition control is finished, the instruction decoder $IDEC_2$ stops the operation of the program counter PC and the output operation of the instruction register $IR_1$ by giving them a control signal PCW and waits for the completion of the repetitive arithmetic processing. When the count in the repeat counter RC becomes zero, the repeat counter RC outputs the countup signal CNTUP, by means of which the instruction decoder $IDEC_1$ recognizes the completion of the repetitive arithmetic processing. Then, the instruction decoder $IDEC_1$ returns the control signals SLC, ID2E, IR2E to the original states that were present during the normal instruction execution sequence. The new state of the control signal SC switches the selector SEL to the instruction register $IR_1$ side and the control signal ID2E causes the instruction decoder $IDEC_2$ to invert the control signal PCW, which in turn enables the program counter PC, allowing the next micro instruction to be decoded by the instruction decoder $IDEC_1$. In this way normal micro instructions can now be executed.

Figure 13 shows an embodiment of a calculation block 42 used to form the application filter of Figure 9. In the figure, designated DRM is a data memory containing tap coefficients $c_0$-$c_n$ shown in Figure 9 each assigned with a unique address. Denoted SRM is a symbol memory such as a shift register that works as a delay element. The calculation block 42 also includes registers $RS_0$, $RS_1$, RB, RG, ESR, RDLT, selector SEL, accumulator ACC, multipliers $MULT_1$, $MULT_2$, arithmetic and logic units $ALU_1$, $ALU_2$, and bus drivers $BDRV_1$, $BDRV_2$. These are controlled by control signals supplied from the instruction decoder $IDEC_1$.

The calculation block 42 is dedicated for use as an application filter and consists of two separate circuits: a filter output calculation processing circuit 72, and a tap coefficient update calculation processing circuit 73.

The filter output calculation processing circuit 72 consists of an input register RB, selector SEL, multiplier $MULT_1$, output register RG, arithmetic and logic unit $ALU_1$, and accumulator ACC. The input signal read out from the symbol memory SRM is transferred by the selector SEL from one of the registers $RS_0$, $RS_1$ to one of input terminals, not shown, of the multiplier $MULT_1$. The tap coefficient read out from the data memory DRM is given to the other input terminal, not shown, of the multiplier $MULT_1$ through the input register RB. The multiplier $MULT_1$ performs multiplication operation on the input tap coefficient (multiplication processing MM of Figure 12) and supplies the multiplied value through the output register RG to one of input terminals, not shown, of the arithmetic and logic unit $ALU_1$. The arithmetic and logic unit $ALU_1$ takes in from the other input terminal an add value held in advance by the accumulator ACC to add up the output value from the register RG and the output value from the accumulator ACC (addition processing TA of Figure 12). Then the arithmetic and logic unit $ALU_1$ outputs the result of addition to the accumulator ACC. When the arithmetic and logic unit $ALU_1$ has added up all the tap outputs for one sample signal, it outputs the value held by the accumulator ACC as the filter output Y onto the common internal data bus 71 through a bus driver $BDRV_1$.

The tap coefficient update calculation processing circuit 73 consists of a register ESR, multiplier $MULT_2$, shifter SHIFT, register RDLT, arithmetic and logic unit $ALU_2$, and data memory DRM. The register ESR contains an error signal. The error signal is multiplied by the multiplier $MULT_2$ with an input signal from the register $RS_0$ (multiplication processing M of Figure 12), and the result of multiplication is shifted a specified number of bits by the shifter SHIFT (update factor K application processing of Figure 12) and then held by the register RDLT. The arithmetic and logic unit $ALU_2$ adds up the tap coefficient update amount held by the register RDLT and the tap coefficient supplied from the data memory DRM (addition processing A of Figure 12). The updated tap coefficient is then written into the same address in the data memory DRM.

The arithmetic and logic unit $ALU_2$ and the data memory DRM form an integrating circuit because the tap coefficients read from the data memory DRM are added with the update amount and then successively written again into the same addresses in the data memory DRM. The data transfer path through which the tap coefficient read from the data memory DRM is fed to the arithmetic and logic unit $ALU_2$ is formed by a dedicated data bus 70. The data memory DRM operates in a so-called read-modify-write mode which performs read and write operations in one machine cycle. The machine cycle characterizes the operation of the calculation block 42 of Figure 13. The dedicated data bus 70 is not shared by other circuit modules but is arranged locally so that the entire length of the bus signal line is minimal, making the unwanted load component very small, allowing the transfer of the tap coefficients to the arithmetic and logic unit $ALU_2$ to be carried out at high speed. This in turn permits the data memory DRM to be read, modified and written easily. Hence, the integrating calculation for updating the tap coefficient for a single tap can be done reliably in one machine cycle. If we let the number of signal lines making up the common internal data bus 71 be m and the number of signal lines making up the dedicated data bus 70 be n, then the relationship m < n holds.

The tap coefficient read from the data memory DRM is also supplied to the register RB via the common internal data bus 71 for filter output calculation. In this case when there is a possibility that the transfer of the tap coefficient on the dedicated data bus 70 may be delayed because of the direct connection of the dedicated data bus 70 to the common internal data bus 71, it is advised that a bus driver $BDRV_2$ that works as a buffer be put between the common internal data bus 71 and the dedicated data bus 70. While the bus drivers $BDRV_1$, $BDRV_2$ are actually provided in numbers equal to those of signal lines (m) that make up the common internal data bus 71, only one each is shown for simplicity. The result of calculation by the calculation block 42 on specified data, i.e., signals indicating that the calculation has produced an overflow or carry are supplied through the instruction register $IDEC_1$ and signal line SL to the instruction register.

Figure 14 shows an embodiment of the flag processing block 43 of Figure 9. Flags 0-m may each be made up of a flip-flop. The instruction decoder $IDEC_2$ decodes an instruction supplied from the instruction register $IR_1$ to form a flag write address FWA and sends it to the address decoder ADC. The address decoder ADC selects flags 0-n+1 according to the flag write address FWA supplied. The selected flags 0-n+1 are either written with "0" by a flag reset signal FR or with "1" by a flag set signal FS, the flag reset and set signals being formed by the instruction decoder $IDEC_2$ decoding the instruction. The instruction decoder $IDEC_2$ decodes the result of calculation fed from the calculation block 42 to form the flag write address FWA and sends it to the address decoder ADO. The address decoder ADC, according to the flag write address FWA supplied, selects flags 0-n+1. The selected flags 0-n+1 are either written with "0" by the flag reset signal FR or with "1" by the flag set signal FS. The flag reset and set signals are produced by the instruction decoder $IDEC_2$ decoding the instruction. Flags n+2-m are set with signals A, B, C, X, Y from the analog front-end unit 11, digital signal processor 12 or protocol control unit 14. The signals A, B, C, X, Y indicate that an external device of the echo cancel LSI 10 is going to make a data transfer to the echo cancel LSI 10 or indicate the state of synchronism of the signal received by the echo cancel LSI 10. The selector SLT, according to a flag read address FRA produced by the instruction decoder $IDEC_2$ decoding the instruction, outputs data stored in a specified one of the flags 0-m to the instruction decoder $IDEC_2$.

The above parallel processing will be explained in more detail. The parallel processing may be achieved by the following description of instructions.

```
RPT (REPEAT)

OP (OPERATION)

CALL SUB (SUBROUTINE CALL INSTRUCTION)

    If Eir (Address No. i) = 1 Goto A

    If Eir (Address No. j) = 1 Goto B

              ↓

    If Eir (Address No. x) = 1 Goto G

    A; Set Reg ← Next state address, goto EXIT

    B; Set Reg ← Next state address, goto EXIT

              ↓

    G; Set Reg ← Next state address, goto EXIT



              EXIT;RETURN

       WAIT (Wait instruction)
```

The "RPT" is a repeat instruction and contains the number of times that the arithmetic instructions are repetitively executed, the number of instructions that need to be executed repetitively, and the preset value of a pointer that generates an operand address required for the execution of the arithmetic instructions.

The "OP" stands for an arithmetic instruction to be executed repetitively according to the repeat instruction and consists of a single or multiple instructions. When the "OP" has multiple instructions, the instruction register $IR_2$ successively holds the arithmetic instructions one at a time and enables each instruction held to be output repetitively. When for example the arithmetic instruction is for an application filter processing such as echo cancel, a single or multiple arithmetic instructions for one tap are described according to the algorithm of Figure 12. Figure 12 shows one example of algorithm for the application filter of a transversal type. In the figure, symbol S represents an input signal; symbol Z represents delay elements that, for example, successively hold the input signals S for a delay time that corresponds to the sampling period of the input signal S; and symbols $C_0$ to $C_n$ indicate tap coefficients. The application filter repeats chronologically the similar processing for each tap. The processing is roughly divided into two parts: an output calculation processing that multiplies the input signal S with a corresponding tap coefficient (MM) and adds up the multiplied values for all taps (TA) to produce the filter output Y; and a tap coefficient update processing that updates the tap coefficients according to the error signal ES. The tap coefficient update processing consists in multiplying the error signal ES with the input signal S (M), applying a tap update factor or convergence factor to the multiplied value (K) to obtain an update amount for the tap coefficient, and adding this update amount to the previous tap coefficient (A) to produce a new or updated tap coefficient. The updated tap coefficients are stored in data memory, assigned with unique addresses. The tap coefficients are fed both to the multiplication MM in the filter output calculation processing and to the addition A in the tap coefficient update processing for the filter. The tap coefficient updated by the addition A is written into the data memory at the same address.

The "CALL SUB" is a subroutine call for the transition state detection and state setting processing. The transition state detection and state setting processing is formed as a subroutine because the processing performed vary depending on the state detected. The subroutine performs detection of a transition state depending on whether the value held in a register in the event information register file 13, which is specified by the address (i, j, ..., x) given by the "If" statement, is logic 1 or logic 0. The subroutine branches to a processing specified by a label (A, B, ..., G) of the "If" statement. The processing specified by the label is the one that sets in an internal register of the digital signal processor an address of the state to be processed next, for example, a start address of the instruction to be executed in the next unit interval. The order of description of the "If" statements conforms to the order of priority in the processing done by the state transition control. After the processing specified by the label has been executed, the control returns from the subroutine to the main program.

The "WAIT" is a wait instruction, which is executed after the program returns from a subroutine. This wait instruction stops the operation of the program counter PC and the output operation of the instruction register $IR_1$ by the control signal PCW to wait for the repetitive calculation to finish. The wait state is canceled when the countup CNTUP output from the repeat counter RC is enabled (count becomes zero).

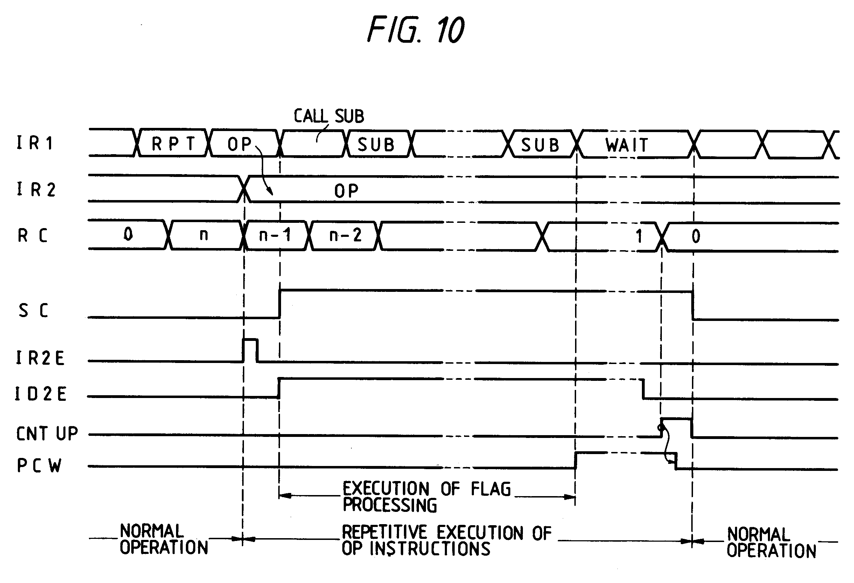

Figure 10 shows a timing diagram for parallel processing of arithmetic instructions and non-arithmetic instructions as executed according to the above-mentioned instruction description. In normal instruction execution sequence, the control signal SC selects the output of the instruction register $IR_1$ and the control signal IR2E inhibits the instruction register $IR_2$ from taking in an instruction. The negated control signal PCW permits the program counter PC and the instruction register $IR_1$ to operate and the negated control signal ID2E keeps the instruction decoder $IDEC_2$ disabled.

When the repeat instruction (RPT) is read out from the micro ROM 41 into the instruction register $IR_1$, the instruction decoder $IDEC_1$ decodes the instruction and presets the execution repeat number n of instruction in the repeat counter RC. In the next operation cycle, an arithmetic instruction (OP) to be executed repetitively is similarly read out from the micro ROM 41 and decoded by the instruction decoder $IDEC_1$ for execution. At this time, the control signal IR2E is temporarily set high, so that the instruction output from the instruction register $IR_1$ is internally transferred to the instruction register $IR_2$. In the succeeding instruction execution cycles, the instruction decoder $IDEC_1$ reverses the state of the control signal ID2E to the enable level (high) to enable the other instruction decoder $IDEC_2$ and switches the selector SEL for the duration in which the control signal SC is kept high to repetitively feed the micro instruction held in the instruction register $IR_2$ to the instruction decoder $IDEC_1$ so that the arithmetic instruction is executed repetitively. During the repetitive execution of the arithmetic instruction, the repeat counter RC decrements the preset value n at each execution of the instruction.

In the mean time, the subroutine call instruction (CALL SUB) described after the arithmetic instruction OP is read out from the micro ROM 41 and fed via the instruction register $IR_1$ to the instruction decoder $IDEC_2$. In this way, various subroutine instructions (SUB), which are non-arithmetic instructions for the state transition control, are executed in parallel with the arithmetic instructions. When the subroutine execution is completed, a wait instruction (WAIT) is read out from the micro ROM 41, which is decoded by the

11

instruction decoder $IDEC_2$ which according to the wait instruction sets the control signal PCW to high level to stop the operation of the program counter PC and the output operation of the instruction register $IR_1$ and wait for the repetitive calculation to be completed. When the countup CNTUP output from the repeat counter RC is set to an enable level, which indicates the count in the repeat counter RC is zero, this is recognized by the instruction decoder $IDEC_1$, which in turn sets the control signal SC to low level, switches the selector SEL to the instruction register $IR_1$ side and sets the control signal PCW to low level. As a result, the program counter PC is enabled to allow the micro instruction described after the wait instruction to be decoded by the instruction decoder $IDEC_1$. In this way, the normal micro instruction can now be executed.

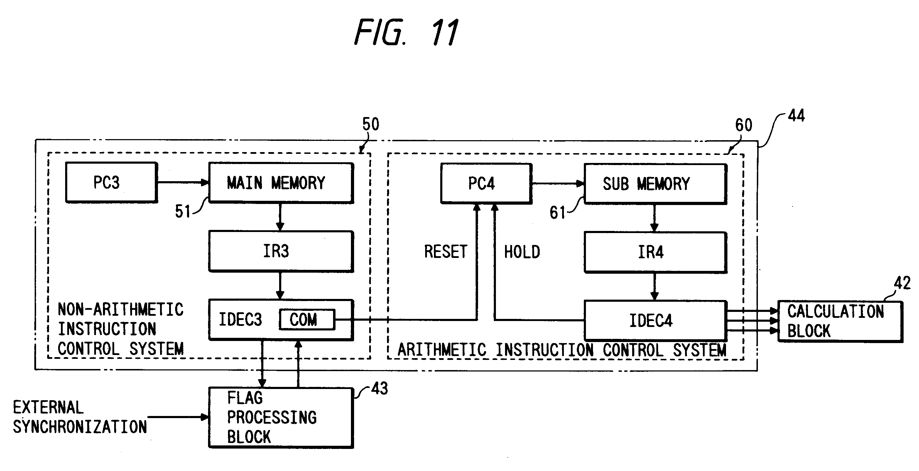

Figure 11 shows another embodiment of the instruction control block of the digital signal processor. The instruction control block 44 consists of an arithmetic instruction control system 60 and a non-arithmetic instruction control system 50. The non-arithmetic instruction control system 50 has a main memory 51 as a control memory and a dedicated program counter PC3, and the arithmetic instruction control system 60 has a submemory 61 and a dedicated program counter PC4. The main memory and submemory are formed by dividing the memory space of the instruction control block 44. The operation of the program counter PC4 in the arithmetic instruction control system 60 is synchronized according to the execution state of the non-arithmetic instructions in the control system 50 so that the arithmetic instructions and the non-arithmetic instructions are executed in parallel at a desired timing. The control logic for the parallel operation is contained in the instruction decoders $IDEC_3$, $IDEC_4$. The main memory 51 contains, as non-arithmetic instructions, a series of micro program descriptions for the transition state detection and setting and instructions for detecting external synchronization flag described at the end of the micro program description. The submemory 61 contains micro programs for arithmetic processing such as application filter processing. The instruction decoder $IDEC_3$ has a comparator circuit COM. The comparator circuit COM compares data set in the comparator circuit COM by a specified instruction to detect an external synchronization flag and data stored in the external synchronization flag in the flag processing block 43 specified by the instruction. When they agree, the comparator circuit COM resets the program counter PC4. This causes arithmetic instructions to be read out successively from the submemory 61 and then decoded by the instruction decoder $IDEC_4$ so that the calculation block can perform arithmetic operations. After the calculation has been executed, the arithmetic instruction control system 60 executes a wait instruction and holds the value of the program counter PC4, standing by. When the instruction decoder $IDEC_3$ sends a reset signal to the program counter PC4 again, the arithmetic instruction control system 60 resumes the arithmetic processing. From the main memory 51 are successively read out non-arithmetic instructions associated with the detection and setting of the transient state. At the end of a series of processing, the non-arithmetic instruction control system 50 continues executing an instruction to detect an external synchronization flag. When the external synchronization flag is detected, the non-arithmetic instruction control system 50 branches to the initial address and again resets the program counter PC4. With such an architecture, the non-arithmetic processing such as detection and setting of transient state can be simultaneously executed with the arithmetic processing, permitting the reduction in the virtual operation cycle number required for a specified processing, as in the above embodiment.

The invention accomplished by the inventor has been described in detail in connection with example embodiments. It should be noted that the invention is not limited to the above embodiments alone and various modifications may be made without departing the spirit of the invention.

For example, the configuration of the analog circuit is not limited to the above embodiments and the A/D convertor also is not restricted to the oversampling type but may be of Nyquist sampling type. When the oversampling type A/D convertor is used, it may be of either delta M, delta sigma or interpolation type. The arithmetic instructions are not limited to the digital signal processing such as filter processing but may be instructions for consecutive data transfers. Further, the non-arithmetic instructions are not limited to the flag processing such as detection and setting of transient state but can be any processing that uses hardware not used in the execution of the arithmetic instruction. While in the above embodiment one example of control memory has been described as a micro ROM, a ROM containing micro programs may be used. When evaluation LSIs are considered, the control memory may be formed with RAM.

Although the above description centered around the echo cancel LSI for ISDN—the field of application from which this invention has originated, this invention is not limited to this application alone but has wide applications ranging from special purpose LSIs dedicated for such processing as voice compression, voice synthesizing, and image emphasizing, to general purpose digital signal processors and to one-chip microcomputers containing analog circuit and digital circuit on the same semiconductor chip.

This invention can widely be applied at least to situations where the operation of a digital circuit which shares the same semiconductor chip with an analog circuit causes noise that will degrade the operation accuracy of the analog circuit, and also to situations where arithmetic instructions and non-arithmetic instructions are executed parallelly.

Representative advantages of the invention disclosed in this application may be briefly outlined as follows.

Since the operation of the digital circuit which shares the semiconductor chip with the analog circuit is stopped while the analog circuit is operating, degradation in the operation precision of the analog circuit due to digital noise can be prevented.

As in analog circuits which include A/D convertors and local D/A convertors using switched capacitor integrating circuits and capacitor arrays, when the analog circuit samples capacitors for information to be processed according to the switch operation timing, the operation of the digital circuit is stopped for a specified duration including the sampling timing. This prevents the levels at the accumulation nodes of the capacitors from being subjected to potential variations due to digital noise transferred through junction capacitance, thereby permitting the information to be accumulated with a desired accuracy. As a result, analog characteristic degradation due to digital noise can be avoided.

As a means to generate such a timing, a clock signal generating means is employed which stops the operation reference clock signal from changing during a specified period which includes a transition timing of a clock signal that controls the sampling switch. With this means, a control can easily be made to stop the operation of the digital circuit for a specified period which includes the capacitor sampling operation.

Since the operation speed of the analog circuit is determined solely by or with a little, if any, degree of freedom by the operation speed and bit accuracy of the system being processed, it is desired that the extra time or capability needed to stop the operation of the digital circuit during the analog circuit operation be provided by the digital circuit. In the digital circuit like a digital signal processor, to execute non-arithmetic instructions in parallel with the execution of the arithmetic instructions achieves a reduction in the number of machine cycles needed for a specified processing.

With the above-mentioned features, it is relatively easy to achieve extra time or capability to stop the operation of the digital circuit during the operation of the analog circuit in order to prevent degradation of analog characteristic due to digital noise.

Hence, if the amount of data to be processed by the digital circuit as a whole in the digital-analog hybrid LSI is constant, and if the processing capacity per unit operation cycle of the digital circuit such as a digital signal processor increases, it is possible to stop the operation of the digital circuit for the period corresponding to the capacity improvement. By having this halt period include the operation timing when the analog circuit is most likely to be affected by the noise, it is possible to prevent deterioration of analog characteristics due to digital noise and thereby guarantee a certain level of characteristic or capability of the digital-analog hybrid LSI as a whole.

The measures taken on the part of the digital circuit act to eliminate the need for increasing the operation frequency of the digital circuit, which in turn contributes to suppressing an increase in the power consumption and digital noise.

The reduction in machine cycle number for a series of processing achieved by parallel execution of the arithmetic and the non-arithmetic processing has an advantage of improving the processing speed not only of the digital-analog hybrid semiconductor integrated circuit but also of individual data processing units such as digital signal processors.

At the same time that a specified arithmetic instruction read out from a control memory is held for multiple operation cycles and during this period is repetitively decoded by a first instruction decoder for execution, a non-arithmetic instruction is read from the control memory and is decoded by the second instruction decoder for execution. This operation allows relatively easily the parallel execution of the arithmetic instruction and the non-arithmetic instruction even when the arithmetic and non-arithmetic instructions are contained in a single control memory.

According to the instruction execution state of one of arithmetic and non-arithmetic instruction control systems, the state of the program counter of the other control system is controlled to parallelly operate the two control systems. With this method, the arithmetic instructions and the non-arithmetic instructions can be parallelly executed even when the arithmetic and non-arithmetic instruction control systems use separate, dedicated control memories.

## Claims

1. A semiconductor integrated device comprising:

   an analog circuit (2) having an analog-digital converter for converting analog signals into digital signals according to a transition of a first clock signal (a),

a digital circuit (3) having decoding means (IDEC1, IDEC2) for decoding first and second instructions supplied according to a transition of a second clock signal (b), and calculation means for performing, according to a transition of the second clock signal (b), a predetermined processing in response to the result of the decoding of the first and the second instructions, and

clock supply means (6) for feeding the first and the second clock signals (a, b) to the analog and digital circuits (2, 3), wherein the clock supply means (6) stops the second clock signal (b) from changing for a predetermined period which includes the transition timing of the first clock signal (a).

2. The device of claim 1, wherein the clock supply means (16) includes first clock generating means (ASG) for generating the first clock signal (a), second clock generating means (DSG) for generating the second clock signal (b), and clock control means (ESG) for controlling the second clock generating means (DSG).

3. The device of claim 2, wherein the second clock generating means (DSG) generates the second clock signal (b) while the clock control means (ESG) outputs a control signal (EN) to the second clock signal generating means (DSG).

4. The device of any of claims 1 to 3, wherein the digital circuit (3) has a digital signal processor (12), which includes said calculation means, said calculation means including a calculation processing unit (42) for performing operations on supplied digital signals and a flag processing unit (43) for performing flag processing, and a control unit (40) for controlling the calculation processing unit (42) and the flag processing unit (43).

5. The device of claim 4, wherein the control unit (40) includes memory means (41) for storing the first instruction for the calculation processing unit (42) and the second instruction for the flag processing unit (43).

6. The device of claim 5, wherein said decoding means is included in the control unit (40) and has a first decoding means (IDEC1) for decoding the first instruction and a second decoding means (IDEC2) for decoding the second instruction.

7. The device of claim 6, wherein the calculation processing unit (42) is controlled in operation according to the decoding result of the first decoding means (IDEC1) and the flag processing unit (43) is controlled in operation according to the decoding result of the second decoding means (IDEC2).

8. The semiconductor integrated device according to claim 7, wherein, when an arithmetic instruction to be repetitively executed a predetermined number of times by the calculation processing unit (42) is supplied, the first decoding means (IDEC1) outputs to the second decoding means (IDEC2) a signal (1D2E) that causes the second decoding means (IDEC2) to start decoding the second instruction supplied from the memory means (41).

9. The device of claim 4, wherein the control unit (44) includes first memory means (61) for storing the first instruction for the calculation processing unit (42) and second memory means (51) for storing the second instruction for the flag processing unit (43).

10. The device of claim 9, wherein said decoding means is included in the control unit (44) and has third decoding means (IDEC4) for decoding the first instruction and fourth decoding means (IDEC3) for decoding the second instruction.

11. The device of claim 10, wherein the fourth decoding means (IDEC3) detects a specified flag in the flag processing unit (43) according to the second instruction supplied from the second memory means (51), and outputs to the first memory means (61) a signal instructing the first memory means (61) to supply the first instruction stored therein to the third decoding means (IDEC4).

12. The device of any of claims 1 to 11, wherein the calculation processing unit (42) includes the calculator and outputs calculated data to cancel echo components transferred from the analog-digital converter.

13. The device of any of claims 1 to 12 and being formed on a single semiconductor chip (1).

# FIG. 1

6 CLOCK SIGNAL GENERATING MEANS

# FIG. 2

DIGITAL
SIGNAL
PROCESSING
UNIT

ANALOG FRONTEND UNIT — 11

DIGITAL SIGNAL
PROCESSOR — 12

EVENT INFORMATION
REGISTER FILE — 13

PROTOCOL
CONTROL
UNIT — 14

15

18

19

TIMING
GENERATOR — 16

17

6

10

ECHO CANCEL LSI

# FIG. 3

Ain → ⊕ (−) → **ANALOG INTEGRATOR** (21) → **f** (22 COMPARATOR) → $\dfrac{1}{1-Z^{-1}}$ (23 DIGITAL INTEGRATOR) → **LOCAL D/A CONVERTOR** (20) → (feedback to ⊕)

A/D OUT

# FIG. 4

21: CI, S3 (φ2), S4 (φ2), S5 (φ1), CS, S1 (φ2), S2 (φ1), Ain

20: 8C, 4C, 2C, C, S61, S62, S71, S72, S81, S82, S91, S92, Vref, GND

FIG. 5

FIG. 6

# FIG. 7

# FIG. 8

1 UNIT INTERVAL

E C

D F C

S L C

STATUS
TRANSITION
CONTROL

STATUS
TRANSITION
CONTROL

m

n

ARITHMETIC PROCESSING CYCLE
NUMBER

NON-ARITHMETIC
PROCESSING
CYCLE NUMBER

# FIG. 9

Block diagram showing INSTRUCTION CONTROL BLOCK (40) including PC, MICRO ROM (41), IR1, IR2, RC, SEL, IDEC1, IDEC2 (IDEC), with signals PCW, SC, SL, ID2E, IR2E, ES, CNTUP; connected to CALCULATION BLOCK (42) and FLAG PROCESSING BLOCK (43).

21

# FIG. 10

EP 0 506 094 A2

# FIG. 11

NON-ARITHMETIC INSTRUCTION CONTROL SYSTEM

- PC3 → MAIN MEMORY (51)
- MAIN MEMORY → IR3
- IR3 → IDEC3 | COM

ARITHMETIC INSTRUCTION CONTROL SYSTEM

- PC4 → SUB MEMORY (61)
- SUB MEMORY → IR4
- IR4 → IDEC4
- RESET, HOLD

IDEC4 → CALCULATION BLOCK (42)

FLAG PROCESSING BLOCK (43)

EXTERNAL SYNCHRONIZATION → FLAG PROCESSING BLOCK

50   60   44

EP 0 506 094 A2

# FIG. 12

## FIG. 13

## FIG. 14

43

FWA → ADC

FLAG 0
FLAG 1
FLAG 2

FR

FS

FLAG n
FLAG n+1
FLAG n+2
FLAG n+3
FLAG n+4

A

B

C

FLAG m-1
FLAG m

X

Y

FRA

SELECTOR
SLT

## FIG. 15

16

17

ASG

DSG

EN

ESG